# EUROPÄISCHE PATENTSCHRIFT

(11) **EP 2 768 918 B1**
(45) Veröffentlichungstag und Bekanntmachung des Hinweises auf die Patenterteilung: **29.04.2020**
(21) Anmeldenummer: 12775253.3
(22) Anmeldetag: 19.10.2012
(51) Int. Cl.: C09J 153/00, C09J 193/00, C03C 27/10, C09K 3/10, C09J 135/02, C09J 7/00, H01L 51/52, B32B 17/06, C08L 53/00, C09J 193/04, C08L 35/02, C08L 93/00

(54) **KLEBEMASSE INSBESONDERE ZUR KAPSELUNG EINER ELEKTRONISCHEN ANORDNUNG**
ADHESIVE SUBSTANCE, IN PARTICULAR FOR ENCAPSULATING AN ELECTRONIC ASSEMBLY
MATIÈRE ADHÉSIVE, EN PARTICULIER POUR ENCAPSULER UN SYSTÈME ÉLECTRONIQUE

(30) Priorität: 21.10.2011 DE 102011085034
(43) Veröffentlichungstag der Anmeldung: 27.08.2014
(73) Patentinhaber: tesa SE, 22848 Norderstedt (DE)
(72) Erfinder: DOLLASE, Thilo, 22397 Hamburg (DE); KRAWINKEL, Thorsten, 22457 Hamburg (DE); BAI, Minyoung, 22529 Hamburg (DE)
(86) Internationale Anmeldenummer: PCT/EP2012/070778
(87) Internationale Veröffentlichungsnummer: WO 2013/057264

(56) Entgegenhaltungen:
- WO-A1-2010/063579
- JP-A- 2009 096 839

## Beschreibung

Die vorliegende Erfindung betrifft eine Klebemasse insbesondere zur Kapselung einer elektronischen Anordnung.

(Opto-)Elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung, verwendet, wobei die Strukturierung in der Regel durch Masken erfolgt.

Als Beispiele für bereits kommerzielle oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und/oder Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von (opto-)elektronischen Anordnungen im Bereich der anorganischen und/oder organischen (Opto-)Elektronik, ganz besonders im Bereich der organischen (Opto-)Elektronik, ist ein Schutz der darin enthaltenen Komponenten vor Permeanten zu sehen. Permeanten können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeanten, wie Sauerstoff und/oder Wasserdampf, darstellen. Daneben gibt es eine Vielzahl von weiteren Anforderungen für derartige (opto-)elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate, wie transparente oder nicht transparente Folien, zum Einsatz, die mehrlagig ausgeführt sein können. Hierbei können sowohl Kombinationen aus verschiedenen Polymeren, als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate wie zum Beispiel Folien, Gewebe, Vliese und Papiere oder Kombinationen daraus möglich.

Um eine möglichst gute Versiegelung zu erzielen, werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Ein geringes Auffließvermögen auf der Anordnung kann durch unvollständige Benetzung der Oberfläche der Anordnung und zurückbleibende Poren die Barrierewirkung an der Grenzfläche verringern, da ein seitlicher Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeanten unter stationären Bedingungen bei bestimmter Permeationsweglänge, Partialdruck und Temperatur. Die Permeabilität P ist das Produkt aus Diffusions-Term D und Löslichkeits-Term S: P = D ^{∗} S

Der Löslichkeitsterm S beschreibt vorliegend die Affinität der Barriereklebemasse zum Permeanten. Im Fall von Wasserdampf wird beispielsweise ein geringer Wert für S von hydrophoben Materialen erreicht. Der Diffusionsterm D ist ein Maß für die Beweglichkeit des Permeanten im Barrierematerial und ist direkt abhängig von Eigenschaften, wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ein geringer Löslichkeitsterm S ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeitsterm), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeitsterm S und Diffusionsterm D notwendig.

Ansätze, um die Barrierewirkung einer Klebemasse zu erhöhen, müssen die beiden Parameter D und S insbesondere im Hinblick auf den Einfluss auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Hierfür werden bisher vor allem Flüssigklebstoffe und Adhäsive auf Basis von Epoxiden verwendet (WO98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexibler Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-)elektronischen Strukturen die Verwendbarkeit derartiger Systeme - die maximal anwendbaren Temperaturen bei (opto-)elektronischen Strukturen liegen oft bei 60 °C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung.

Insbesondere wenn die (opto-)elektronischen Anordnungen flexibel sein sollen, ist es wichtig, dass der verwendete Kleber nicht zu starr und spröde ist. Daher sind besonders Haftklebemassen und hitzeaktiviert verklebbare Klebefolien geeignet für eine solche Verklebung. Um auf den Untergrund gut aufzufließen, aber gleichzeitig eine hohe Verklebungsfestigkeit zu erzielen, sollten die Klebemassen zunächst möglichst weich sein, dann aber vernetzt werden können. Als Vernetzungsmechanismen lassen sich je nach chemischer Basis der Klebemasse Temperaturhärtungen und/oder Strahlenhärtungen durchführen. Während die Temperaturhärtung recht langsam ist, können Strahlungshärtungen innerhalb weniger Sekunden initiiert werden. Daher sind Strahlenhärtungen, insbesondere die UV-Härtung, insbesondere bei kontinuierlichen Herstellverfahren bevorzugt.

Die DE 10 2008 060 113 A1 beschreibt ein Verfahren zur Kapselung einer elektronischen Anordnung gegen Permeanten, bei dem eine Haftklebemasse auf Basis von Butylenblockcopolymeren, insbesondere Isobutylenblockcopolymeren, genutzt wird, und die Verwendung einer solchen Klebemasse in einem Kapselungsverfahren. In Kombination mit den Elastomeren werden bestimmte Harze, charakterisiert durch DACP- und MMAP-Werte bevorzugt. Die Klebemasse ist zudem bevorzugt transparent und kann UV-blockende Eigenschaften zeigen. Als Barriereeigenschaften weist die Klebemasse bevorzugt ein WVTR von < 40 g/m²*d und ein OTR von < 5000 g/m²*d bar auf. In dem Verfahren kann die Haftklebemasse während und/oder nach der Applikation erwärmt werden. Die Haftklebemasse kann vernetzt werden zum Beispiel strahlenchemisch. Es werden Substanzklassen vorgeschlagen, über die eine solche Vernetzung vorteilhaft ausgeführt werden kann. Jedoch werden keine konkreten Beispiele gegeben, die zu besonders geringer Volumen- und Grenzflächenpermeation bei hoher Transparenz und Flexibilität führen.

Die EP 1 518 912 A1 lehrt eine Klebemasse zur Kapselung eines Elektrolumineszenzelements, die eine photokationisch härtbare Verbindung und einen photokationischen Initiator enthält. Die Härtung erfolgt nach Lichtstimulation als Dunkelreaktion. Der Kleber ist bevorzugt auf Epoxy-Basis. Acrylate und deren radikalische Härtung sind nicht Teil dieser Schrift. Es können aliphatische Hydroxide und Polyether als covernetzende Komponenten zugesetzt sein. Zudem kann ein Klebharz enthalten sein, um Adhäsion und Kohäsion einzustellen. Darunter kann auch Polyisobutylen sein. Es werden keine speziellen Angaben zur Verträglichkeit der einzelnen Bestandteile gemacht und auch keinen Angaben zu Molmassen der Polymere gemacht.

JP 4,475,084 B1 lehrt transparente Siegelmassen für organische Elektrolumineszenzelemente, diese können auf Blockcopolymerbasis sein. Als Beispiele sind SIS und SBS sowie die hydrierten Varianten aufgeführt. Nicht genannt sind jedoch Bestandteile, die eine Vernetzung nach Applikation erlauben. Ebenso wenig wird auf die Barriereeigenschaften der Siegelmassen eingegangen. Offenbar übernimmt die Siegelschicht keine spezielle Barriereaufgabe.

Die US 2006/100299 A1 offenbart eine Haftklebemasse, die ein Polymer mit einer Erweichungstemperatur im Sinne der US 2006/100299 A1 von größer +60 °C, ein polymerisierbares Harz mit einer Erweichungstemperatur im Sinne der US 2006/100299 A1 von kleiner +30 °C und einen Initiator enthält, der zu einer Reaktion zwischen Harz und Polymer führen kann. Reaktiv ausgestattete Polymere sind aber nicht universell verfügbar, so dass man bei der Auswahl dieser Polymerbasis eingeschränkt ist, wenn es um weitere Eigenschaften und Kosten geht. Zudem bringt jede Art von Funktionalisierung (über die Reaktivität geschaffen werden soll) einen Anstieg an Grundpolarität und damit eine unerwünschte Erhöhung an Wasserdampfpermeabilität. Es sind keine Copolymere basierend auf Isobutylen oder Butylen genannt, und es werden keine Angaben zu Molmassen der Polymer gemacht.

Die US 2009/026934 A1 beschreibt Klebemassenschichten zur Verkapselung organischer Elektrolumineszenzelemente. Die Klebemassen enthalten Polyisobutylen und ein hydriertes Kohlenwasserstoffharz. Zur Vernetzung nach Applikation können verschiedene Reaktivharze wie auch Acrylate eingesetzt werden. WVTR-Werte liegen bei den Beispielen typischerweise zwischen 5 und 20 g/m²*d. OTR-Werte sind nicht angegeben. Polyisobutylenpolymere können als Copolymer genutzt werden, erzeugt durch Copolymerisation mit anderen weichen Monomeren. Die Molmassen der Polymere liegen üblicherweise bei > 500 000 g/mol.

Die WO 2008/144080 A1 lehrt Aufbauten mit empfindlichen organischen Schichten, die gekapselt sind. Die Kapselung erfolgt durch einen gehärteten elastomeren Laminierkleber. Als Kleber kommen Mischungen aus reaktiven Oligomeren und/oder Polymeren und reaktiven Monomeren zum Einsatz. Härtung kann über Strahlung oder Wärme erfolgen. Die Reaktivität wird der Beschreibung nach über (Meth)acrylat-Gruppen eingebracht. Copolymere als Elastomerbasis sind nicht genannt, und es werden auch keine Angaben zu den Molmassen der Polymere gemacht.

Aufgabe der Erfindung ist es, eine Klebemasse zur Verfügung zu stellen, die den schädlichen Einfluss von Sauerstoff und Wasserdampf auf empfindliche Funktionsschichten wie zum Beispiel im Bereich von organischen Photozellen für Solarmodule oder im Bereich von organischen Licht emittierenden Dioden (OLEDs) durch eine gute Barrierewirkung gegenüber den schädlichen Substanzen unterbinden kann, die verschiedene Bauteile der Funktionselemente miteinander verbinden kann, die gut handhabbar in Verklebungsprozessen ist, die eine flexible und saubere Verarbeitung erlaubt und die trotzdem beim Hersteller einfach zu verarbeiten ist

Gelöst wird diese Aufgabe durch eine Klebemasse, wie sie im Hauptanspruch näher gekennzeichnet ist. In den Unteransprüchen sind vorteilhafte Ausführungsformen der Erfindung beschrieben. Des Weiteren ist die Verwendung der erfindungsgemäßen Klebemasse umfasst.

Demgemäß betrifft die Erfindung eine Klebemasse, vorzugsweise Haftklebemasse umfassend
(a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist,
(b) zumindest eine Sorte eines zumindest teilhydrierten Klebharzes,
(c) zumindest eine Sorte eines Reaktivharzes auf Basis eines Acrylats oder Methacrylats mit einer Erweichungstemperatur von kleiner 40 °C, bevorzugt kleiner 20 °C,
(d) zumindest eine Sorte eines Photoinitiators für die Initiierung einer radikalischen Härtung.

Bei amorphen Stoffen entspricht die Erweichungstemperatur dabei der Glasübergangstemperatur, bei (semi)kristallinen Stoffen entspricht die Erweichungstemperatur dabei der Schmelztemperatur.

Im Bereich der Klebstoffe zeichnen sich Haftklebemassen insbesondere durch ihre permanente Klebrigkeit und Flexibilität aus. Ein Material, das permanente Haftklebrigkeit aufweist, muss zu jedem Zeitpunkt eine geeignete Kombination aus adhäsiven und kohäsiven Eigenschaften aufweisen. Für gute Haftungseigenschaften gilt es, Haftklebemassen so einzustellen, dass eine optimale Balance aus adhäsiven und kohäsiven Eigenschaften besteht.
Vorzugsweise ist die Klebemasse eine Haftklebemasse, also eine viskoelastische Masse, die bei Raumtemperatur in trockenem Zustand permanent klebrig und klebfähig bleibt. Die Klebung erfolgt durch leichten Anpressdruck sofort auf fast allen Substraten.

Das oder die Copolymere sind gemäß einer vorteilhaften Ausführungsform statistische, alternierende, Block-, Stern- und/oder Pfropfcopolymere mit einer Molmasse M_{w} (Gewichtsmittel) von 300.000 g/mol oder kleiner, bevorzugt 200.000 g/mol oder kleiner. Kleinere Molgewichte sind dabei aufgrund ihrer besseren Verarbeitbarkeit bevorzugt.

Als Copolymere kommen zum Beispiel statistische Copolymere aus mindestens zwei verschiedenen Monomersorten zum Einsatz, von denen zumindest eine Isobutylen oder Butylen ist und zumindest eine weitere ein Comonomer mit einer - als hypothetisches Homopolymer betrachtet - Erweichungstemperatur von größer 40 °C. Vorteilhafte Beispiele für diese zweite Comonomersorte sind Vinylaromaten (auch teil- oder vollhydrierte Varianten), Methylmethacrylat, Cyclohexylmethacrylat, Isobornylmethacrylat und Isobornylacrylat.
Besonders bevorzugte Beispiele sind Styrol und α-Methylstyrol, wobei diese Aufzählung keinen Anspruch auf Vollständigkeit erhebt.

Weiter vorzugsweise sind das oder die Copolymere Block-, Stern- und/oder Pfropfcopolymere, die zumindest eine Sorte eines ersten Polymerblocks ("Weichblock") mit einer Erweichungstemperaturvon kleiner -20 °C und zumindest eine Sorte eines zweiten Polymerblocks ("Hartblock") mit einer Erweichungstemperatur von größer +40 °C aufweisen.

Der Weichblock ist dabei bevorzugt unpolar aufgebaut und enthält bevorzugt Butylen oder Isobutylen als Homopolymerblock oder Copolymerblock, letztere vorzugsweise mit sich selbst oder miteinander oder mit weiteren besonders bevorzugt unpolaren Comonomeren copolymerisiert. Als unpolare Comonomere sind beispielsweise (teil-) hydriertes Polybutadien, (teil-)hydriertes Polyisopren und/oder Polyolefine geeignet.

Der Hartblock ist bevorzugt aus Vinylaromaten (auch teil- oder vollhydrierte Varianten), Methylmethacrylat, Cyclohexylmethacrylat, Isobornylmethacrylat und/oder Isobornylacrylat aufgebaut. Besonders bevorzugte Beispiele sind Styrol und α-Methylstyrol, wobei diese Aufzählung keinen Anspruch auf Vollständigkeit erhebt. Der Hartblock enthält damit die zumindest eine Comonomersorte, die - als hypothetisches Homopolymer betrachtet - eine Erweichungstemperatur von größer 40 °C aufweist.

In einer besonders vorteilhaften Ausführungsform sind die beschriebenen bevorzugten Weich- und Hartblöcke gleichzeitig in dem oder den Copolymeren verwirklicht.

Es ist vorteilhaft, wenn es sich bei dem zumindest einen Blockcopolymer um ein Triblockcopolymer handelt, das aus zwei endständigen Hartblöcken und einem mittelständige Weichblock aufgebaut ist. Diblockcopolymere sind ebenfalls gut geeignet wie auch Gemische aus Tri- und Diblockcopolymeren.

Sehr bevorzugt werden Triblockcopolymere vom Typ Polystyrol-block-Polyisobutylenblock-Polystyrol eingesetzt. Solche Systeme sind unter den Bezeichnungen SIBStar von der Firma Kaneka und Oppanol IBS von der Firma BASF bekannt gemacht worden. Weitere vorteilhaft einsetzbare Systeme sind in EP 1 743 928 A1 beschrieben.

Dadurch, dass die Copolymere einen Anteil an Isobutylen oder Butylen als zumindest eine Comonomersorte enthalten, resultiert eine unpolare Klebemasse, die vorteilhaft niedrige Volumenbarriereeigenschaften insbesondere gegenüber Wasserdampf bieten. Die im Gegensatz zum Stand der Technik geringen Molmassen der Copolymere erlauben eine gute Verarbeitbarkeit beim Hersteller, insbesondere in Formulierungs- und Beschichtungsprozessen. Geringe Molmasse führt zu verbesserter und schnellerer Löslichkeit, wenn Lösungsmittel basierende Prozesse gewünscht sind (besonders bei Isobutylen- und Butylen-Polymeren ist die Auswahl an geeigneten Lösungsmitteln gering). Es sind zudem höhere Copolymerkonzentrationen in der Lösung möglich. Auch in Lösungsmittel freien Prozessen zeigt sich eine erfindungsgemäß niedrige Molmasse als vorteilhaft, da die Schmelzeviskosität geringer ist als bei Vergleichssystemen mit höherer Molmasse.

Bloße Reduktion der Molmasse führt zwar naturgemäß zu besserer Löslichkeit und niedrigeren Lösungs- und Schmelzeviskositäten. Jedoch leiden mit der geringeren Molmasse andere anwendungstechnisch wichtige Eigenschaften wie zum Beispiel die Kohäsion einer Klebemasse. Hier steuert der erfinderische Einsatz der zumindest zweiten Comonomer-Sorte mit der für ein hypothetisches Homopolymer eigenen Erweichungstemperaturvon größer 40 °C effektiv entgegen.

Die erfindungsgemäße Klebemasse enthält zumindest eine Sorte eines zumindest teilhydrierten Klebharzes, vorteilhaft solche, die mit dem Copolymer beziehungsweise, sofern ein aus Hart- und Weichblöcken aufgebautes Copolymer eingesetzt wird, hauptsächlich mit dem Weichblock verträglich sind (Weichharze).
Es ist vorteilhaft, wenn dieses Klebharz eine Klebharzerweichungstemperatur von größer 25 °C aufweist. Es ist darüber hinaus vorteilhaft, wenn ergänzend zumindest eine Sorte Klebharz mit einer Klebharzerweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Als Harze können in der Haftklebemasse zum Beispiel partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder β-Pinen und/oder δ-Limonen, hydrierte Polymerisate von bevorzugt reinen C₈- und C₉-Aromaten. Vorgenannte Klebharze können sowohl allein als auch im Gemisch eingesetzt werden

Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt.
Des Weiteren sind unpolare Harze mit einem DACP-Wert (diacetone alcohol cloud point) oberhalb von 30 °C und einem MMAP-Wert (mixed methylcylohexane aniline point) von größer 50 °C, insbesondere mit einem DACP-Wert oberhalb von 37 °C und einem MMAP-Wert größer 60 °C bevorzugt. Der DACP-Wert und der MMAP-Wert geben jeweils die Löslichkeit in einem bestimmten Lösemittel an. Durch die Auswahl dieser Bereiche wird eine besonders hohe Permeationsbarriere, insbesondere gegen Wasserdampf, erreicht.

Die erfindungsgemäße Klebemasse enthält weiterhin zumindest eine Sorte eines Reaktivharzes auf Basis eines Acrylats oder Methacrylats für die strahlenchemische und gegebenenfalls thermische Vernetzung mit einer Erweichungstemperatur von kleiner 40 °C, bevorzugt kleiner 20 °C.
Bei den Reaktivharzen auf Basis von Acrylaten oder Methacrylaten handelt es sich insbesondere um aromatische oder insbesondere aliphatische oder cycloaliphatische Acrylate oder Methacrylate.
Geeignete Reaktivharze tragen zumindest eine (Meth)acrylat-Funktion, bevorzugt zumindest zwei (Meth)acrylat-Funktionen. Weitere Verbindungen mit zumindest einer (Meth)acrylat-Funktion, bevorzugt höherer (Meth)acrylat-Funktionalität einzusetzen, ist im Sinne dieser Erfindung möglich.

Kommen Verbindungen zum Einsatz, die lediglich eine (Meth)acrylat-Funktion tragen, werden im Sinne dieser Erfindung bevorzugt (Meth)acrylat-Reaktivharze eingesetzt, die der allgemeinen Strukturformel (I) entsprechen.

CH₂=C(R¹)(COOR²) (I)

In Struktur (I) bedeuten R¹ = H oder CH₃ und R² lineare, verzweigte oder ringförmige, aliphatische oder aromatische Kohlenwasserstoffreste mit 1 bis 30 C-Atomen.

Reaktivharze, die sehr bevorzugt im Sinne der allgemeinen Struktur (I) eingesetzt werden, umfassen Acryl- und Methacrylsäureester mit Alkylgruppen bestehend aus 4 bis 18 C-Atomen. Spezifische Beispiele für entsprechende Verbindungen sind, ohne sich durch diese Aufzählung einschränken zu wollen, n-Butylacrylat, n-Butylmethacrylat, n-Pentylacrylat, n-Pentylmethacrylat, n-Hexylacrylat, n-Hexylmethacrylat, n-Heptylacrylat, n-Heptylmethacrylat, n-Octylacrylat, n-Octylmethacrylat, n-Nonylacrylat, n-Nonylmethacrylat, Laurylacrylat, Laurylmethacrylat, Hexadecylacrylat, Hexadecylmethacrylat, Stearylacrylat, Stearylmethacrylat, Behenylacrylat, Behenylmethacrylat, deren verzweigte Isomere wie zum Beispiel 2-Ethylhexylacrylat, 2-Ethylhexylmethacrylat, iso-Octylacrylat, iso-Octylmethacrylat, iso-Decylacrylat, iso-Decylmethacrylat, Tridecylacrylat, Tridecylmethacrylat sowie cyclische Monomere wie zum Beispiel Cyclohexylacrylat, Cyclohexylmethacrylat, Tetrahydrofurfurylacrylat, Tetrahydrofurfurylmethacrylat, Dihydrodicyclopentadienylacrylat, Dihydrodicyclopendadienylmethacrylat, 4-tert-Butylcyclohexylacrylat, 4-tert-Butylcyclohexylmethacrylat, Norbornylacrylat, Norbornylmethacrylat, Isobornylacrylat und Isobornylmethacrylat.

Weiterhin einsetzbar sind Acryloylmorpholin, Methacryloylmorpholin, Trimethylolpropanformalmonoacrylat, Trimethylolpropanformalmonomethacrylat, propoxyliertes Neopentylmethylethermonoacrylat, propoxyliertes Neopentylmethylethermonomethacrylat, Tripropylenglykolmethylethermonoacrylat, Tripropylenglykolmethylethermonomethacrylat, ethoxyliertes Ethylacrylat wie Ethyldiglykolacrylat, ethoxyliertes Ethylmethacrylat wie Ethyldiglykolmethacrylat, propoxyliertes Propylacrylat und propoxyliertes Propylmethacrylat.

Ebenfalls einsetzbar als Reaktivharze sind Acryl- und Methacrylsäureester, die aromatische Reste enthalten, wie zum Beispiel Phenylacrylat, Benzylacrylat, Phenylmethacrylat, Benzylmethacrylat, Phenoxyethylacrylat, Phenoxyethylmethacrylat, ethoxyliertes Phenolacrylat, ethoxyliertes Phenolmethacrylat, ethoxyliertes Nonylphenolacrylat oder ethoxyliertes Nonylphenolmethacrylat.

Weiterhin können aliphatische oder aromatische insbesondere ethoxylierte oder propoxylierte Polyethermono(meth)acrylate, aliphatische oder aromatische Polyestermono(meth)acrylate, aliphatische oder aromatische Urethanmono(meth)acrylate oder aliphatische oder aromatische Epoxymono(meth)acrylate als Verbindungen, die eine (Meth)acrylat-Funktion tragen, eingesetzt werden.

Bevorzugt werden als Verbindungen, die zumindest zwei (Meth)acrylat-Funktionen tragen, eine oder mehrere Verbindungen aus der Liste umfassend difunktionelle aliphatische (Meth)acrylate wie 1,3-Propandioldi(meth)acrylat, 1,4-Butandioldi(meth)acrylat, 1,6-Hexandioldi(meth)acrylat, 1,5-Neopentyldi(meth)acrylat, Dipropylenglykoldi(meth)acrylat, Tricyclodecandimethyloldi(meth)acrylat, Cyclohexandimethanoldi(meth)acrylat, trifunktionelle aliphatische (Meth)acrylate wie Trimethylolpropantri(meth)acrylat, tetrafunktionelle aliphatische (Meth)acrylate wie Dimethylolpropantetra(meth)acrylat oder Trimethylolpropantetra(meth)acrylat, pentafunktionelle aliphatische (Meth)acrylate wie Dipentaerythritolmonohydroxypenta(meth)acrylat, hexafunktionelle aliphatische (Meth)acrylate wie Dipentaerythritolhexa(meth)acrylat eingesetzt. Ferner, wenn höherfunktionalisierte Verbindungen eingesetzt werden, können aliphatische oder aromatische insbesondere ethoxylierte und propoxylierte Polyether(meth)acrylate mit insbesondere zwei, drei, vier oder sechs (Meth)acrylat-Funktionen wie ethoxyliertes Bisphenol A Di(meth)acrylat, Polyethylenglykoldi(meth)acrylat, propoxyliertes Trimethylolpropantri(meth)acrylat, propoxyliertes Glyceroltri(meth)acrylat, propoxyliertes Neopentylglyceroldi(meth)acrylat, ethoxyliertes Trimethyloltri(meth)acrylat, ethoxyliertes Trimethylolpropandi(meth)acrylat, ethoxyliertes Trimethylolpropantri(meth)acrylat, Tetraethylenglykoldi(meth)acrylat, ethoxyliertes Neopentylglykoldi(meth)acrylat, propoxyliertes Pentaerythritoltri(meth)acrylat, Dipropylenglykoldi(meth)acrylat, ethoxyliertes Trimethylolpropanmethyletherdi(meth)acrylat, aliphatische oder aromatische Polyester(meth)acrylate mit insbesondere zwei, drei, vier oder sechs (Meth)acrylat-Funktionen, aliphatische oder aromatische Urethan(meth)acrylate mit insbesondere zwei, drei, vier oder sechs (Meth)acrylat-Funktionen, aliphatische oder aromatische Epoxy(meth)acrylate mit insbesondere zwei, drei, vier oder sechs (Meth)acrylat-Funktionen genutzt werden.
Die Klebmasseformulierung enthält zudem zumindest eine Sorte eines Photoinitiators für die radikalische Härtung der Reaktivharze. Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar.
Geeignete Vertreter für Photoinitiatoren für die radikalische Härtung sind Typ-I-Photoinitiatoren, also sogenannte α-Spalter wie Benzoin- und Acetophenon-Derivate, Benzilketale oder Acylphosphinoxide, Typ-II-Photoinitiatoren, also sogenannte Wasserstoffabstraktoren wie Benzophenon-Derivate und einige Chinone, Diketone und Thioxanthone. Ferner können Triazin-Derivate zur Initiierung radikalischer Reaktionen verwendet werden.

Vorteilhaft einsetzbare Photoinitiatoren vom Typ I umfassen beispielsweise Benzoin, Benzoinether wie beispielsweise Benzoinmethylether, Benzoin-iso-propylether, Benzoinbutylether, Benzoin-iso-butylether, Methylolbenzoin-Derivate wie Methylolbenzoinpropylether, 4-Benzoyl-1,3-dioxolan und seine Derivate, Benzilketal-Derivate wie 2,2-Dimethoxy-2-phenylacetophenon oder 2-Benzoyl-2-phenyl-1,3-dioxolan, α,α-Dialkoxyacetophenone wie α,α-Dimethoxyacetophenon und α,α-Diethoxyacetophenon, α-Hydroxyalkylphenone wie 1-Hydroxycyclohexylphenylketon, 2-Hydroxy-2-methyl-1-phenylpropanon und 2-Hydroxy-2-methyl-1-(4-iso-propylphenyl)-propanon, 4-(2-Hydroxyethoxy)-phenyl-2-hydroxy-2-methyl-2-propanon und seine Derivate, α-Aminoalkylphenone wie 2-Methyl-1-[4-(methylthio)-phenyl]-2-morpholinopropan-2-on und 2-Benzyl-2-dimethylamino-1-(4-morpholinophenyl)-butan-1-on, Acylphosphinoxide wie 2,4,6-Trimethylbenzoyldiphenylphosphinoxid und Ethyl-2,4,6-trimethylbenzoylphenylphosphinat und O-Acyl-α-oximinoketone.

Vorteilhaft einsetzbare Photoinitiatoren vom Typ II umfassen beispielsweise Benzophenon und seine Derivate wie 2,4,6-Trimethylbenzophenon oder 4,4'-Bis-(dimethylamino)-benzophenon, Thioxanthon und seine Derivate wie 2-iso-Propylthioxanthon und 2,4-Diethylthioxanthon, Xanthon und seine Derivate und Anthrachinon und seine Derivate.

Typ-II-Photoinitiatoren werden besonders vorteilhaft in Kombination mit stickstoffhaltigen Coinitiatoren, den sogenannten Amin-Synergisten eingesetzt. Bevorzugt werden im Sinne dieser Erfindung tertiäre Amine verwendet. Ferner kommen in Kombination mit Typ-II-Photoinitiatoren vorteilhaft Wasserstoffatomdonoren zur Anwendung. Beispiele hierfür sind Substrate, die Amino-Gruppen enthalten. Beispiele für Amin-Synergisten sind Methyldiethanolamin, Triethanolamin, Ethyl-4-(dimethylamino)-benzoat, 2-n-Butoxyethyl-4-(dimethylamino)-benzoat, 2-Ethylhexyl-4-(dimethylamino)-benzoat, 2-(Dimethylaminophenyl)-ethanon sowie ungesättigte und damit copolymerisierbare tertiäre Amine, (meth)acrylierte Amine, ungesättigte Amin-modifizierte Oligomere und Polymere auf Polyester- oder Polyetherbasis und Amin-modifizierte (Meth)acrylate.

Es können außerdem polymerisierbare Photoinitiatoren vom Typ I und/oder Typ II eingesetzt werden.

Im Sinne dieser Erfindung können auch beliebige Kombinationen verschiedener Arten von Typ-I und/oder Typ-II Photoinitiatoren eingesetzt werden.

Dem Fachmann sind weitere Systeme bekannt, die ebenfalls erfindungsgemäß einsetzbar sind.

Bevorzugt wird die Haftklebemasse erst nach der Applikation auf der elektronischen Anordnung teil- oder endvernetzt.

Der Klebemasse können übliche Zuschlagstoffe wie Alterungsschutzmittel (Antiozonantien, Antioxidantien, Lichtschutzmittel usw.) zugesetzt sein.
Als Additive zur Klebemasse werden typischerweise genutzt:
- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Netzadditive
- Haftvermittler
- Endblockverstärkerharze und/oder
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine

Die Zuschlagstoffe oder Additive sind nicht zwingend, die Klebemasse funktioniert auch, ohne dass diese einzeln oder in beliebiger Kombination zugesetzt sind.

Füllstoffe können vorteilhaft in erfindungsgemäßen Haftklebemassen eingesetzt werden. Bevorzugt werden als Füllstoffe der Klebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen µm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Des Weiteren können auch organische Absorber wie beispielsweise Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden eingesetzt werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen, sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Klebemasse zu stark herabzusetzen oder weitere Eigenschaften zu beeinträchtigen. Je nach Füllstofftyp können Füllstoffanteile von größer 40 Gew.-% bis 70 Gew.-% erreicht werden.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.
Die Füllstoffe sind nicht zwingend, die Klebemasse funktioniert auch, ohne dass diese einzeln oder in beliebiger Kombination zugesetzt sind.

Weiter bevorzugt kommt eine Klebemasse zum Einsatz, die in bestimmten Ausführungen im sichtbaren Licht des Spektrums (Wellenlängenbereich von etwa 400 nm bis 800 nm) transparent ist. Die gewünschte Transparenz lässt sich insbesondere durch die Verwendung farbloser Klebharze und durch Einstellung der Kompatibilität von Copolymer (in mikrophasenseparierten Systemen wie Block- und Pfropfcopolymeren mit deren Weichblock) und Klebharz aber auch mit dem Reaktivharz erzielen. Reaktivharze werden für diesen Zweck vorteilhaft aus aliphatischen und cycloaliphatischen Systemen ausgewählt. Eine derartige Haftklebemasse eignet sich somit auch besonders gut für einen vollflächigen Einsatz über einer (opto-)elektronischen Struktur. Eine vollflächige Verklebung bietet, bei einer etwa mittigen Anordnung der elektronischen Struktur gegenüber einer Randversiegelung den Vorteil, dass der Permeant durch die gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

"Transparenz" bedeutet dabei eine mittlere Transmission der Klebemasse im sichtbaren Bereich des Lichts von mindestens 75 %, bevorzugt höher als 90 %, wobei sich diese Betrachtung auf unkorrigierte Transmission, also ohne Grenzflächenreflexionsverluste herauszurechnen, bezieht.

Vorzugsweise zeigt die Klebemasse einen Haze kleiner 5,0 %, bevorzugt kleiner 2,5 %.

Die Herstellung und Verarbeitung der Haftklebemasse kann aus Lösung, Dispersion sowie aus der Schmelze erfolgen. Bevorzugt erfolgt die Herstellung und Verarbeitung aus Lösung oder aus der Schmelze. Besonders bevorzugt ist die Fertigung der Klebmasse aus Lösung. Dabei werden die Bestandteile der Haftklebemasse in einem geeigneten Lösungsmittel, zum Beispiel Toluol oder Mischungen aus Benzin und Aceton, gelöst und mit allgemein bekannten Verfahren auf den Träger aufgebracht. Bei der Verarbeitung aus der Schmelze können dies Auftragsverfahren über eine Düse oder einen Kalander sein. Bei Verfahren aus der Lösung sind Beschichtungen mit Rakeln, Messern, Walzen oder Düsen bekannt, um nur einige zu nennen.
Über die Beschichtungstemperatur kann in lösungsmittelfreien Prozessen das Beschichtungsergebnis beeinflusst werden. Dem Fachmann sind die Prozessparameter geläufig, um transparente Klebeschichten zu erhalten. In Lösungsmittelbeschichtungsprozessen kann über die Auswahl des Lösungsmittels oder des Lösungsmittelgemischs das Beschichtungsergebnis beeinflusst werden. Dem Fachmann ist auch hier geläufig, geeignete Lösungsmittel auszuwählen. Kombinationen aus bevorzugt unpolaren Lösungsmitteln, die unter 100 °C sieden, mit Lösungsmitteln, die oberhalb 100 °C sieden, insbesondere aromatische, sind sehr gut geeignet.

Vorteilhaft ist die Beschichtung aus Lösungsmitteln oder aus der Schmelze. Hierfür bieten erfindungsgemäße Formulierungen große Vorteile, wie bereits weiter oben ausgeführt wurde.

Besonders vorteilhaft lässt sich die erfindungsgemäße Klebemasse in einem ein- oder doppelseitig klebenden Klebeband verwenden. Diese Darreichungsart erlaubt eine besonders einfache und gleichmäßige Applikation der Klebemasse.

Der allgemeine Ausdruck "Klebeband" umfasst dabei ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-)elektronischen Anordnungen verwendet werden.
Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Sehr gut als Trägerfolien sind auch solche aus Dünngläsern. Diese sind in Schichtdicken von weniger als 1 mm und sogar in 30 µm zum Beispiel. D 263 T der Firma Schott oder Willow Glass der Firma Corning verfügbar. Dünnglasfolien lassen sich durch Zulaminieren einer Kunststofffolie (zum Beispiel Polyester) mittels eines Transferklebebands, sofern gewünscht, weiter stabiliseren.

Bevorzugt werden als Dünngläser solche mit einer Dicke von 15 bis 200 µm, vorzugsweise 20 bis 100 µm, weiter vorzugsweise 25 bis 75, besonders vorzugsweise 30 bis 50 µm eingesetzt.

Vorteilhafterweise werden ein Borosilikatglas wie D263 T eco der Firma Schott, ein Alkali-Erdalkali-Silikatglas oder ein Aluminoborosilikatglas wie AF 32 eco ebenfalls von der Firma Schott, eingesetzt.
Ein alkalifreies Dünnglas wie AF32 eco ist vorteilhaft, weil die UV-Transmission höher ist. Für UV-härtende Klebstoffsysteme können daher Initiatoren mit Absorptionsmaxima im UV-C-Bereich besser verwendet werden, was die Stabilität der unvernetzten Klebemassen gegenüber Tageslicht erhöht.
Ein alkalihaltiges Dünnglas wie D263 T eco ist vorteilhaft, weil der Wärmeausdehnungskoeffizient höher ist und besser mit den polymeren Bestandteilen des weiteren OLED-Aufbaus zusammenpasst.

Derartige Gläser können im Down-Draw-Prozess, wie er in WO 00/41978 A1 referenziert ist, oder in Verfahren hergestellt werden, wie sie beispielsweise in der EP 1 832 558 A1 offenbart sind. In WO 00/41978 A1 sind weiterhin Verfahren offenbart, Verbunde aus Dünnglas und Polymerschichten oder -folien herzustellen.

Besonders bevorzugt sind diese Folien/Folienverbunde, insbesondere die Polymerfolien mit einer Permeationsbarriere für Sauerstoff und Wasserdampf versehen, wobei die Permeationsbarriere die Anforderungen für den Verpackungsbereich übertrifft (WVTR < 10⁻¹ g/(m²d); OTR < 10⁻¹ cm³/(m²d bar)).

Bei Dünnglasfolien oder Dünnglasfolienverbünden ist auf Grund der intrinsisch hohen Barriereeigenschaften des Glases eine entsprechende Beschichtung nicht erforderlich.

Dünnglasfolien oder Dünnglasfolienverbünde werden bevorzugt, wie in der Regel auch Polymerfolien, als Band von einer Rolle bereitgestellt. Entsprechende Gläser werden von der Firma Corning bereits unter der Bezeichung Willow Glass angeboten. Diese Lieferform lässt sich hervorragend mit einer bevorzugt ebenfalls bandförmig bereitgestellten Klebemasse laminieren.

Zudem können die Folien/Folienverbunde in bevorzugter Ausgestaltung transparent ausgebildet sein, damit auch der Gesamtaufbau eines derartigen Klebeartikels transparent ausgebildet ist. "Transparenz" bedeutet auch hier eine mittlere Transmission im sichtbaren Bereich des Lichts von mindestens 75 %, bevorzugt höher als 90 %.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.

In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Des Weiteren sind die Klebemasse sowie ein eventuell damit gebildetes Klebeband hervorragend zur Kapselung einer elektronischen Anordnung gegen Permeanten geeignet, indem die Klebemasse oder das Klebeband auf und/oder um die zu kapselnden Bereiche der elektronischen Anordnung appliziert werden.

Als Kapselung wird vorliegend nicht nur ein vollumfänglicher Einschluss mit der genannten Haftklebemasse bezeichnet sondern auch bereits eine bereichsweise Applikation der Haftklebemasse auf den zu kapselnden Bereichen der (opto-) elektronischen Anordnung, beispielsweise eine einseitige Überdeckung oder eine Umrahmung einer elektronischen Struktur.

Im Prinzip können mit Klebebändern zwei Arten der Verkapselung durchgeführt werden. Entweder wird das Klebeband zuvor ausgestanzt und nur um die zu kapselnden Bereiche herum verklebt, oder es wird vollflächig über die zu kapselnden Bereiche geklebt. Ein Vorteil der zweiten Variante ist die einfachere Handhabung und der häufig bessere Schutz.

Die vorliegende Erfindung beruht zunächst auf der Erkenntnis, dass es trotz der zuvor beschriebenen Nachteile möglich ist, eine (Haft-)Klebemasse zur Kapselung einer elektronischen Anordnung zu verwenden, bei der die zuvor bezüglich Haftklebemassen beschriebenen Nachteile nicht oder nur vermindert auftreten. Es hat sich nämlich gezeigt, dass eine Klebemasse basierend auf einem Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist, zur Kapselung elektronischer Anordnungen besonders geeignet ist.
Da es sich bei der Klebemasse vorzugsweise um eine Haftklebemasse handelt, ist die Applikation besonders einfach, da keine Vorfixierung erfolgen muss. Die Haftklebemassen erlauben eine flexible und saubere Verarbeitung. Je nach Ausgestaltung der Haftklebemasse ist auch keine nachfolgende Behandlung mehr erforderlich. Auch kann durch die Darreichung als Haftklebeband die Menge der Haftklebemasse einfach dosiert werden, und es fallen auch keine Lösemittelemissionen an.

Vorteil der hier vorliegenden Erfindung ist also, im Vergleich zu anderen Haftklebemassen, die Kombination aus sehr guten Barriereeigenschaften gegenüber Sauerstoff und vor allem gegenüber Wasserdampf bei gleichzeitiger guter Grenzflächenhaftung auf unterschiedlichen Substraten, guten kohäsiven Eigenschaften und, im Vergleich zu Flüssigklebstoffen, eine sehr hohe Flexibilität und eine einfache Applikation in der (opto-)elektronischen Anordnung und bei/in der Kapselung. Des Weiteren liegen in bestimmten Ausführungen auch hochtransparente Klebemassen vor, die in besonderer Weise für den Einsatz in (opto-)elektronischen Anordnungen Anwendung finden können, da eine Verminderung von einfallendem oder austretendem Licht sehr gering gehalten wird.

Eine Verkapselung durch Lamination von zumindest Teilen der (opto-)elektronischen Aufbauten mit einem flächigen Barrierematerial (zum Beispiel Glas, insbesondere Dünnglas, metalloxidbeschichteten Folien, Metallfolien, Multilayer-Substratmaterialien) ist mit sehr guter Barrierewirkung in einem einfachen Rolle-zu-Rolle Prozess möglich. Die Flexibilität des gesamten Aufbaus hängt, neben der Flexibilität der Haftklebemasse von weiteren Faktoren, wie Geometrie und Dicke der (opto-)elektronischen Aufbauten beziehungsweise der flächigen Barrierematerialien ab. Die hohe Flexibilität der Haftklebemasse ermöglicht es aber sehr dünne, biegsame und flexible (optoelektronische Aufbauten zu realisieren.

Von besonderem Vorteil für die Kapselung von (opto-)elektronischen Aufbauten ist es, wenn diese vor, während oder nach der Applikation der Haftklebemasse erwärmt werden. Dadurch kann die Haftklebemasse noch besser auffließen und somit die Permeation an der Grenzfläche zwischen der (opto-)elektronischen Anordnung und der Haftklebemasse weiter vermindert werden. Die Temperatur sollte dabei bevorzugt mehr als 30 °C, weiter bevorzugt mehr als 50 °C betragen, um das Auffließen entsprechend zu fördern. Zu hoch sollte die Temperatur jedoch nicht gewählt werden, um die (opto-)elektronische Anordnung nicht zu beschädigen. Die Temperatur sollte möglichst weniger als 100 °C betragen. Als optimaler Temperaturbereich haben sich Temperaturen zwischen 50 °C und 70 °C herausgestellt. Vorteilhaft ist es ebenso, wenn die Haftklebemasse vor, während oder nach der Applikation zusätzlich oder alternativ erwärmt wird. Zusammengefasst erfüllt die erfindungsgemäße Klebemasse alle Anforderungen, wie sie an eine Klebemasse gestellt werden, die zur Verkapselung einer (opto-)elektronischen Anordnung eingesetzt wird:
- eine geringe Volumenpermeation von Wasserdampf und Sauerstoff, was sich in einem Wert für WVTR (Mocon) von kleiner 10 g/m² d, und einem Wert für OTR (Mocon) von kleiner 1000 cm³/m²*d*bar zeigt,
- eine geringe Grenzflächenpermeation von Wasserdampf und Sauerstoff, was sich in einem Wert für WVTR (Ca-Test) von kleiner 1 g/m² d zeigt und ein gutes Auffließen der Klebemasse auf die Zielsubstrate bedingt;
- optional, aber bevorzugt hohe Transparenz mit einer Transmission von bevorzugt über 90%,
- optional, aber bevorzugt ein Haze kleiner 5,0 % bevorzugt kleiner 2,5 %
- hervorragendes Laminationsverhalten zum Beispiel im Rolle-zu-Rolle-Prozess, was sich in einer Klebkraft für das unvernetzte System auf Glas größer 1,5 N/cm, bevorzugt größer 2,5 N/cm und einer dynamischen Scherfestigkeit für das vernetzte System auf Glas von größer 25 N/cm², bevorzugt größer 50 N/cm², sehrt bevorzugt größer 100 N/cm² zeigt

Weitere Einzelheiten, Ziele, Merkmale und Vorteile der vorliegenden Erfindung werden nachfolgend anhand mehrerer, bevorzugte Ausführungsbeispiele darstellende Figuren näher erläutert. Es zeigen
- Fig. 1: eine erste (opto-)elektronische Anordnung in schematischer Darstellung,
- Fig. 2: eine zweite (opto-)elektronische Anordnung in schematischer Darstellung,
- Fig. 3: eine dritte (opto-)elektronische Anordnung in schematischer Darstellung.

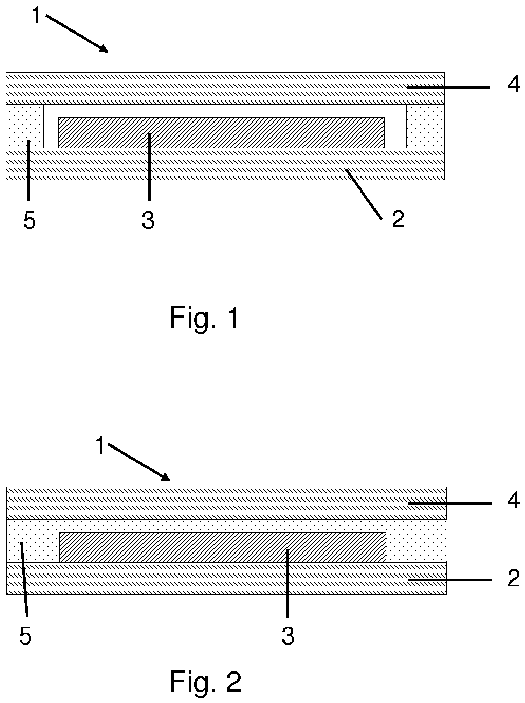

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeanten ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.
Um die elektronische Struktur 3 auch zur Seite hin zu kapseln und gleichzeitig die Abdeckung 4 mit der elektronischen Anordnung 1 im Übrigen zu verbinden, ist eine Haftklebemasse 5 umlaufend neben der elektronischen Struktur 3 auf dem Substrat 2 vorgesehen. In anderen Ausführungsformen erfolgt die Kapselung nicht mit einer reinen Haftklebemasse 5, sondern mit einem Klebeband 5, das zumindest eine erfindungsgemäße Haftklebemasse enthält. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.

Bei der Haftklebemasse 5 handelt es sich um eine solche auf Basis der erfindungsgemäßen Haftklebemasse wie sie vorstehend in allgemeiner Form beschrieben wurde und nachfolgend in Ausführungsbeispielen näher dargelegt ist. Die Haftklebemasse 5 übernimmt vorliegend nicht nur die Funktion des Verbindens des Substrats 2 mit der Abdeckung 4 sondern bildet zudem auch eine Barriereschicht für Permeanten bereit, um so die elektronische Struktur 3 auch von der Seite gegen Permeanten wie Wasserdampf und Sauerstoff zu kapseln.

Die Haftklebemasse 5 wird vorliegend zudem in Form eines Stanzlings aus einem doppelseitigen Klebebandes bereitgestellt. Ein derartiger Stanzling ermöglicht eine besonders einfache Applikation.

Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Haftklebemasse 5 vollflächig angeordnet. Die elektronische Struktur 3 wird somit von oben vollständig durch die Haftklebemasse 5 gekapselt. Auf die Haftklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

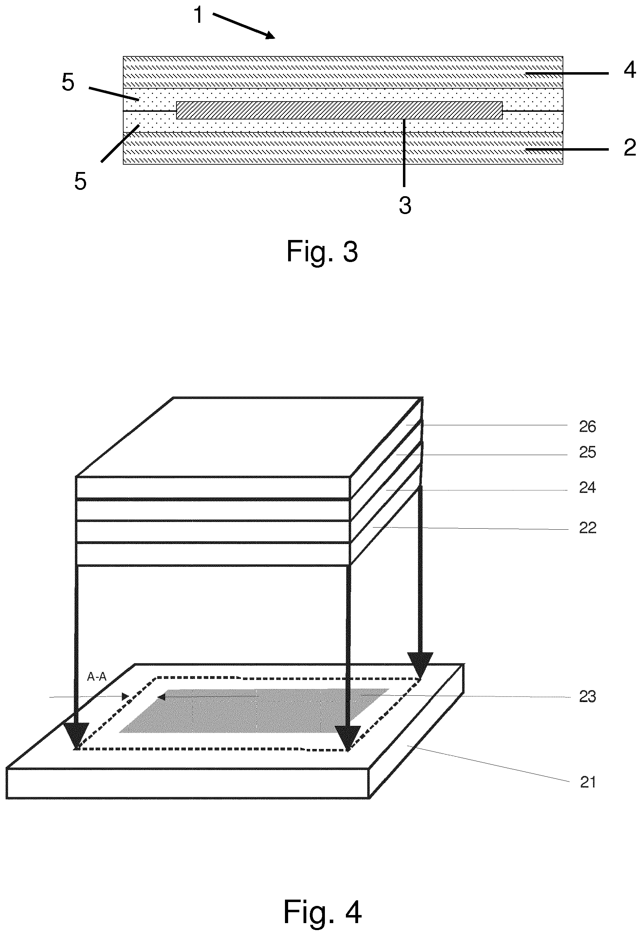

Fig. 3 zeigt eine weitere alternative Ausgestaltung einer (opto-)elektronischen Anordnung 1. Im Gegensatz zu den vorherigen Ausgestaltungen sind nun zwei Haftklebemassen 5a, 5b vorgesehen, die vorliegend identisch ausgebildet sind. Die erste Haftklebemasse 5a ist vollflächig auf dem Substrat 2 angeordnet. Auf der Haftklebemasse 5a ist die elektronische Struktur 3 vorgesehen, die durch die Haftklebemasse 5a fixiert wird. Der Verbund aus Haftklebemasse 5a und elektronischer Struktur 3 wird dann mit der weiteren Haftklebemasse 5b vollflächig überdeckt, so dass die elektronische Struktur 3 von allen Seiten durch die Haftklebemassen 5a, b gekapselt ist. Oberhalb der Haftklebemasse 5b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeanten zur elektronischen Struktur 3 weiter einzuschränken.

Insbesondere im Hinblick auf die Fig. 2, 3 wird darauf hingewiesen, dass es sich vorliegend um schematische Darstellungen handelt. Aus den Darstellungen ist insbesondere nicht ersichtlich, dass die Haftklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum oder unter erhöhtem Druck durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Die Applikation der Haftklebemasse 5 erfolgt in allen gezeigten Ausführungsbeispielen in Form eines Haftklebebandes. Dabei kann es sich grundsätzlich um ein doppelseitiges Haftklebeband mit einem Träger oder um ein Transferklebeband handeln. Vorliegend ist eine Ausgestaltung als Transferklebeband gewählt.

Die Dicke der Haftklebemasse, die entweder als Transferklebeband oder auf einem flächigen Gebilde beschichtet vorliegt, beträgt bevorzugt zwischen etwa 1 µm und etwa 150 µm, weiter bevorzugt zwischen etwa 5 µm und etwa 75 µm und besonders bevorzugt zwischen etwa 12 µm und 50 µm. Hohe Schichtdicken zwischen 50 µm und 150 µm werden dann eingesetzt wenn eine verbesserte Haftung auf dem Substrat und/oder eine dämpfende Wirkung innerhalb des (opto-)elektronischen Aufbaus erreicht werden soll. Nachteilig ist hier jedoch der erhöhte Permeationsquerschnitt. Geringe Schichtdicken zwischen 1 µm und 12 µm reduzieren den Permeationsquerschnitt, damit die laterale Permeation und die Gesamtdicke des (opto-)elektronischen Aufbaus. Jedoch kommt es zu einer Verringerung der Haftung auf dem Substrat. In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung. Die optimale Dicke hängt vom (opto-)elektronischen Aufbau, der Endanwendung, der Art der Ausführung der Haftklebemasse und gegebenenfalls dem flächigen Substrat ab.

Für doppelseitige Klebebänder gilt für die Barriereklebemasse(n) ebenfalls, dass die Dicke der einzelnen Haftklebemasseschicht(en) bevorzugt zwischen etwa 1 µm und etwa 150 µm, weiter bevorzugt zwischen etwa 5 µm und etwa 75 µm und besonders bevorzugt zwischen etwa 12 µm und 50 µm liegt. Kommt in doppelseitigen Klebebändern neben der einen erfindungsgemäßen Barriereklebemasse eine weitere zum Einsatz, dann kann es auch vorteilhaft sein, wenn ihre Dicke oberhalb 150 µm liegt.

Im Folgenden wird die Erfindung durch einige Beispiele näher erläutert, ohne die Erfindung damit einschränken zu wollen.

### Prüfmethoden

### Klebkraft

Die Bestimmung der Klebkraft wurde wie folgt durchgeführt: Als definierter Haftgrund wurden Glasplatten (Floatglas) eingesetzt. Dem verklebbaren Flächenelement wurde auf der Seite des leichter trennenden Liners eine 36 µm PET-Folie zukaschiert. Das zu untersuchende verklebbare Flächenelement wurde auf eine Breite von 20 mm und eine Länge von etwa 25 cm zugeschnitten, mit einem Handhabungsabschnitt versehen und unmittelbar danach fünfmal mit einer Stahlrolle von 4 kg bei einem Vorschub von 10 m/min auf den jeweils gewählten Haftgrund aufgedrückt. Unmittelbar im Anschluss daran wurde das zuvor verklebte Flächenelement in einem Winkel von 180° bei Raumtemperatur und mit 300 mm/min vom Haftgrund mit einem Zugprüfungsgerät (Firma Zwick) abgezogen und die hierfür benötigte Kraft gemessen. Der Messwert (in N/cm) ergab sich als Mittelwert aus drei Einzelmessungen. Die Prüfung erfolgte an unvernetzten Mustern.

### Dynamischer Schertest

Ein Transferklebeband wird zwischen zwei Glasplatten (Floatglas) verklebt und mittels UV-Licht gehärtet. Nach einer Lagerung von 24 h wird der Verbund in der Zugprüfmaschine mit 50 mm/min bei 23 °C und 50% rel. Feuchte so getrennt, dass die beiden Glasplatten unter einem Winkel von 180° auseinander gezogen wurden, und die Maximalkraft in N/cm² ermittelt. Dabei wird ein quadratisches Prüfmuster mit einer Kantenlänge von 25 mm untersucht.

### Permeabilität für Sauerstoff (OTR) und Wasserdampf (WVTR)

Die Bestimmung der Permeabilität für Sauerstoff (OTR) und Wasserdampf (WVTR) erfolgt nach DIN 53380 Teil 3 beziehungsweise ASTM F-1249. Die Haftklebemasse wird dazu mit einer Schichtdicke von 50 µm auf eine permeable Membran aufgebracht. Die Sauerstoffdurchlässigkeit wird bei 23 °C und einer relativen Feuchte von 50 % gemessen mit einem Messgerät Mocon OX-Tran 2/21. Die Wasserdampfdurchlässigkeit wird bei 37,5 °C und einer relativen Feuchte von 90 % bestimmt.

### Lebensdauertest

Als ein Maß für die Bestimmung der Lebensdauer eines elektronischen Aufbaus wurde ein Calciumtest herangezogen. Dieser ist in der Figur 4 gezeigt. Dazu wird im Vakuum eine 20 x 20 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (26 x 26 mm²) mit der zu testenden Klebemasse 22 sowie einer Dünnglasscheibe 24 (35 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 3 mm (A-A) abdeckt. Aufgrund des undurchlässigen Glasträgers 24 wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 25 µm vollflächig und blasenfrei verklebt. Der Messwert (in h) ergab sich als Mittelwert aus drei Einzelmessungen.

Aus der Zeit bis zum vollständigen Abbau des Calciumspiegels wird zudem eine Wasserdampfpermeationsrate (Ca-WVTR) berechnet. Dazu wird die Masse des aufgedampften Calciums mit dem Faktor 0,9 multipliziert (Massenverhältnis H₂O/Ca für die Umsetzungsreaktion von metallischem Calcium zu transparentem Calciumhydroxid) um die Masse des einpermeierten Wasserdampfes zu ermitteln. Diese wird auf den Permeationsquerschnitt (Umfangslänge des Testaufbaus x Klebemassedicke) sowie die Zeit bis zum vollständigen Abbau des Calciumspiegels bezogen. Der errechnete Messwert wird weiterhin durch die Breite des allseitig überstehenden Rands (in mm) geteilt und somit auf eine Permeationsstrecke von 1 mm normiert. Die Angabe des Ca-WVTR erfolgt in g/m²*d.

### Klebharzerweichungstemperatur

Die Klebharzerweichungstemperatur wird nach der einschlägigen Methodik durchgeführt, die als Ring and Ball bekannt ist und nach ASTM E28 standardisiert ist.

Zur Bestimmung der Klebharzerweichungstemperatur der Harze kommt ein Ring-Kugel-Automat HRB 754 der Firma Herzog zum Einsatz. Harzmuster werden zunächst fein gemörsert. Das resultierende Pulver wird in einen Messingzylinder mit Bodenöffnung (Innendurchmesser am oberen Teil des Zylinders 20 mm, Durchmesser der Bodenöffnung des Zylinders 16 mm, Höhe des Zylinders 6 mm) gefüllt und auf einem Heiztisch geschmolzen. Die Befüllmenge wird so gewählt, dass das Harz nach dem Schmelzen den Zylinder ohne Überstand voll ausfüllt.

Der resultierende Probekörper wird samt Zylinder in die Probehalterung des HRB 754 eingelegt. Zur Befüllung des Temperierbads wird Glycerin verwendet, sofern die Klebharzerweichungstemperatur zwischen 50 °C und 150 °C liegt. Bei niedrigeren Klebharzerweichungstemperaturen kann auch mit einem Wasserbad gearbeitet werden. Die Prüfkugeln haben einen Durchmesser von 9,5 mm und wiegen 3,5 g. Entsprechend der HRB 754 Prozedur wird die Kugel oberhalb des Probekörpers im Temperierbad angeordnet und auf dem Probekörper abgelegt. 25 mm unter dem Zylinderboden befindet sich eine Auffangplatte, 2 mm über dieser eine Lichtschranke. Während des Messvorgangs wird die Temperatur mit 5 °C/min erhöht. Im Temperaturbereich der Klebharzerweichungstemperatur beginnt sich die Kugel durch die Bodenöffnung des Zylinders zu bewegen, bis sie schließlich auf der Auffangplatte zum Stehen kommt. In dieser Position wird sie von der Lichtschranke detektiert und zu diesem Zeitpunkt die Temperatur das Temperierbads registriert. Es findet eine Doppelbestimmung statt. Die Klebharzerweichungstemperatur ist der Mittelwert aus den beiden Einzelmessungen.

### Erweichungstemperatur

Die Erweichungstemperatur von Copolymeren, Hart- und Weichblöcken und ungehärteten Reaktivharzen wird kalorimetrisch über die Differential Scanning Calorimetry (DSC) nach DIN 53765:1994-03 bestimmt. Aufheizkurven laufen mit einer Heizrate von 10 K/min. Die Muster werden in Al-Tiegeln mit gelochtem Deckel und Stickstoffatmosphäre vermessen. Es wird die zweite Aufheizkurve ausgewertet. Bei amorphen Stoffen treten Glasübergangstemperaturen auf, bei (semi)kristallinen Stoffen Schmelztemperaturen. Ein Glasübergang ist als Stufe im Thermogramm erkennbar. Die Glasübergangstemperatur wird als Mittelpunkt dieser Stufe ausgewertet. Eine Schmelztemperatur ist als Peak im Thermogramm erkennbar. Als Schmelztemperatur wird diejenige Temperatur notiert, bei der die höchste Wärmetönung auftritt.

### Transmission

Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Wellenlängen zwischen 800 nm und 400 nm bei einer Auflösung von 1 nm. Es wurde eine Leerkanalmessung als Referenz über den gesamten Wellenlängenbereich durchgeführt. Für die Angabe des Ergebnisses wurden die Transmissionsmessungen im angegebenen Bereich gemittelt. Eine Korrektur von Grenzflächenreflextionsverlusten wird nicht vorgenommen.

### HAZE-Messung

Der HAZE-Wert beschreibt den Anteil des transmittierten Lichts, der von der durchstrahlten Probe nach vorne großwinklig gestreut wird. Somit quantifiziert der HAZE-Wert Materialfehler in der Oberfläche oder der Struktur, die die klare Durchsicht stören. Das Verfahren zur Messung des Haze-Wertes wird in der Norm ASTM D 1003 beschrieben. Die Norm erfordert die Messung von vier Transmissionsmessungen. Für jede Transmissionmessung wird der Lichttransmissionsgrad berechnet. Die vier Transmissionsgrade werden zum prozentualen Haze-Wert verrechnet. Der HAZE-Wert wird mit einem Haze-gard Dual von Byk-Gardner GmbH gemessen.

### Molekulargewicht

Die Bestimmung des mittleren Molekulargewichtes M_{W} (Gewichtsmittel) - auch Molmasse genannt - erfolgt mittels Gelpermeationschromatographie (GPC). Als Eluent wird THF mit 0,1 Vol.-% Trifluoressigsäure eingesetzt. Die Messung erfolgt bei 25 °C. Als Vorsäule wird PSS-SDV, 5 µm, 10³ Å, ID 8,0 mm x 50 mm verwendet. Zur Auftrennung wurden die Säulen PSS-SDV, 5 µm, 10³ Å, 10⁵ Å und 10⁶ Å mit jeweils ID 8,0 mm × 300 mm eingesetzt. Die Probenkonzentration beträgt 4 g/l, die Durchflussmenge 1,0 ml pro Minute. Es wird gegen PS-Standards gemessen.

Sofern nicht anders angegeben, sind alle Mengenangaben in den nachfolgenden Beispielen Gewichtsprozente beziehungsweise Gewichtsteile bezogen auf die Gesamtzusammensetzung.

### Beispiel 1

Als Copolymer wurde ein Polystyrol-block-Polyisobutylen Blockcopolymer der Firma Kaneka ausgewählt. Der Anteil an Styrol im Gesamtpolymer beträgt 20 Gew.-%. Es wurde Sibstar 62M (300 g) verwendet. Die Molmasse beträgt 60.000 g/mol. Die Glasübergangstemperatur der Polystyrolblöcke betrug 100 °C und der Polyisobutylenblöcke -60 °C. Als Klebharz kam Escorez 5300 (Ring and Ball 105 °C, DACP = 71, MMAP = 72) der Firma Exxon, ein vollhydriertes Kohlenwasserstoffharz (200 g) zum Einsatz. Als Reaktivharz wurde SR833S der Firma Sartomer ausgewählt, ein cycloaliphatisches Diacrylat (500 g).
Diese Rohstoffe wurden in einem Gemisch aus Toluol (300 g), Aceton (150 g) und Siedegrenzenbenzin 60/95 (550 g) gelöst, so dass eine 50 Gew.-% Lösung entsteht.

Anschließend wird der Lösung ein Photoinitiator zugesetzt. Hierzu wurden 5 g Irgacure 500 (bezogen von Firma BASF) abgewogen. Der Photoinitiator weist ein Absorptionsmaximum im Bereich 300 nm bis 370 nm auf.

Mittels eines Rakelverfahrens wurde die Formulierung aus Lösung auf einen silikonisierten PET-Liner beschichtet und bei 120 °C für 15 min getrocknet. Der Masseauftrag betrug 50 g/m². Das Muster wurde mit einer weiteren Lage eines silikonisierten aber leichter trennenden PET-Liners eingedeckt.

Aus diesen Mustern wurden Probekörper für Klebkraftmessungen erzeugt. Die Klebkraft auf Glas (Floatglas) betrug 2,3 N/cm. Es wurden zudem Muster für dynamische Schertests erzeugt (die Härtung erfolgte mit einer undotierten Quecksilberlampe mit einer Dosis von 80 mJ/cm²). Der Test auf dynamische Scherfestigkeit ergab 195 N/cm².

Die Muster wurden in eine Glove-Box eingeschleust. Ein Teil der Muster wurde dem Lebensdauertest unterzogen. Dabei wurde durch das Abdeckglas mittels UV-Licht gehärtet (Dosis: 80 mJ/cm²; Lampentyp: undotierter Quecksilberstrahler). Dieses Muster wurde für den Lebensdauertest verwendet. Weitere Muster wurden ohne vorherige Laminierung mittels UV unter gleichen Bedingungen wie oben angegeben durch den PET-Liner gehärtet. Diese Muster wurden für WVTR- und OTR-Messungen (Mocon) verwendet und für die Ausprüfung optischer Eigenschaften.

Das Ergebnis aus der WVTR-Messung (Mocon) ergab 6 g/m²*d und aus der OTR-Messung (Mocon) 300 cm³/m²*d*bar. Der Lebensdauertest bestimmt über die zeitliche Veränderung eines Ca-Dots (Ca-WVTR) ergab 0,6 g/m²*d.

Die Untersuchung der optischen Eigenschaften der gehärteten Muster nach Ausdeckung beider PET-Liner ergab eine Transmission von 92 % und einen Haze von 1,3 %.

### Beispiel 2

Es wurde eine einseitig klebende Klebefolie hergestellt. Dazu wurde für die Klebemasse als Copolymer ein Polystyrol-block-Polyisobutylen-Blockcopolymer der Firma Kaneka ausgewählt. Der Anteil an Styrol im Gesamtpolymer beträgt 20 Gew.-%. Es wurde Sibstar 62M zu 334 g verwendet. Die Molmasse beträgt 60.000 g/mol. Die Glasübergangstemperatur der Polystyrolblöcke beträgt 100 °C und der Polyisobutylenblöcke -60 °C. Als Klebharz kam Escorez 5300 (Ring and Ball 105 °C, DACP = 71, MMAP = 72) der Firma Exxon, ein vollhydriertes Kohlenwasserstoffharz, mit 333 g zum Einsatz. Als Reaktivharz wurde SR833S der Firma Sartomer ausgewählt, ein cycloaliphatisches Diacrylat (333 g). Diese Rohstoffe wurden in einem Gemisch aus Toluol (300 g), Aceton (150 g) und Siedegrenzenbenzin 60/95 (550 g) gelöst, so dass eine 50 Gew.-% Lösung entsteht.

Anschließend wurde der Lösung ein Photoinitiator zugesetzt. Hierzu wurden 5 g Irgacure 500 (bezogen von Firma BASF) abgewogen. Der Photoinitiator weist ein Absorptionsmaximum im Bereich 300 nm bis 370 nm auf.

Mittels eines Rakelverfahrens wurde die Formulierung aus Lösung auf einen silikonisierten PET-Liner beschichtet und bei 120 °C für 15 min getrocknet. Der Masseauftrag betrug 50 g/m². Das Muster wurde mit einer Lage eines flexiblen Dünnglases (D 263 T der Firma Schott in 30 µm Dicke) eingedeckt.

Die Muster wurden in eine Glove-Box eingeschleust. Ein Teil der Muster wurde dem Lebensdauertest unterzogen. Dabei wurde durch den Dünnglasträger mittels UV-Licht gehärtet (Dosis: 80 mJ/cm²; Lampentyp: undotierter Quecksilberstrahler). Dieses Muster wurde für den Lebensdauertest (Ca-Test) verwendet, der einen Ca-WVTR von 0,52 g/m²d ergab.

Die Beispiele demonstrieren nicht nur die besondere Eignung der erfindungsgemäßen Klebemasse, sondern auch die erfolgreiche Verwendung eines Klebebands mit einem Dünnglas beziehungsweise Dünnglaslaminat als Trägermaterial eines Klebebands zur Verkapselung gegen Permeate.

## Patentansprüche

1. Klebemasse insbesondere zur Kapselung einer elektronischen Anordnung gegen Permeanten, umfassend
(a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist,
(b) zumindest eine Sorte eines zumindest teilhydrierten Klebharzes,
(c) zumindest eine Sorte eines Reaktivharzes basierend auf Acrylaten oder Methacrylaten mit einer Erweichungstemperatur von kleiner 40 °C, bevorzugt kleiner 20 °C,
(d) zumindest eine Sorte eines Photoinitiators für die Initiierung einer radikalischen Härtung.

2. Klebemasse nach Anspruch 1,
**dadurch gekennzeichnet, dass**
das oder die Copolymere statistische, alternierende, Block-, Stern- und/oder Pfropfcopolymere mit einer Molmasse M_{w} von 300.000 g/mol oder kleiner, bevorzugt 200.000 g/mol oder kleiner sind.

3. Klebemasse nach Anspruch 1 oder 2,
**dadurch gekennzeichnet, dass**
das oder die Copolymere Block-, Stern- und/oder Pfropfcopolymere sind, die zumindest eine Sorte eines ersten Polymerblocks ("Weichblock") mit einer Erweichungstemperaturvon kleiner -20 °C und zumindest eine Sorte eines zweiten Polymerblocks ("Hartblock") mit einer Erweichungstemperaturvon größer +40 °C aufweisen.

4. Klebemasse nach Anspruch 3,
**dadurch gekennzeichnet, dass**
der Weichblock unpolar aufgebaut ist und Butylen oder Isobutylen als Homopolymerblock oder Copolymerblock enthält, letztere vorzugsweise mit sich selbst oder miteinander oder mit weiteren besonders bevorzugt unpolaren Comonomeren copolymerisiert.

5. Klebemasse nach Anspruch 3 oder 4,
**dadurch gekennzeichnet, dass**
der Hartblock aus Styrol, Styrol-Derivaten und/oder aus anderen aromatischen oder (cyclo-)aliphatischen Kohlenwasserstoffmonomeren oder aus Methacrylaten oder aus Acrylaten aufgebaut ist.

6. Klebemasse nach zumindest einem der vorhergehenden Ansprüche,
**dadurch gekennzeichnet, dass**
es sich bei dem zumindest einen Blockcopolymer um ein Triblockcopolymer handelt, das aus zwei endständigen Hartblöcken und einem mittelständigen Weichblock aufgebaut ist.

7. Klebemasse nach zumindest einem der vorhergehenden Ansprüche,
**dadurch gekennzeichnet, dass**
das oder die Klebharze einen Hydrierungsgrad von mindestens 70 %, weiter bevorzugt von mindestens 95 % aufweisen.

8. Klebemasse nach zumindest einem der vorhergehenden Ansprüche,
**dadurch gekennzeichnet, dass**
die Klebemasse zumindest ein Harz enthält, das einen DACP-Wert von mehr als 30 °C und einen MMAP-Wert von mehr als 50 °C aufweist, vorzugsweise einen DACP-Wert von mehr als 37 °C und einen MMAP-Wert von mehr als 60 °C.

9. Klebemasse nach zumindest einem der vorhergehenden Ansprüche,
**dadurch gekennzeichnet, dass**
die Klebemasse zumindest ein Reaktivharz enthält, das aliphatischer oder cycloaliphatischer Natur ist.

10. Klebemasse nach zumindest einem der vorhergehenden Ansprüche,
**dadurch gekennzeichnet, dass**
die Klebemasse Photoinitiatoren enthält, die unterhalb 350 nm UV-Licht absorbieren und die eine radikalische Härtung erlauben.

11. Klebemasse nach zumindest einem der vorhergehenden Ansprüche,
**dadurch gekennzeichnet, dass**
die Klebemasse Photoinitiatoren enthält, die oberhalb 250 nm und unterhalb 350 nm UV-Licht absorbieren.

12. Klebemasse nach zumindest einem der vorhergehenden Ansprüche,
**dadurch gekennzeichnet, dass**
die Haftklebemasse ein oder mehrere Additive enthält,
vorzugsweise ausgewählt aus der Gruppe bestehend aus Plastifizierungsmitteln, primären Antioxidantien, sekundären Antioxidantien, Prozessstabilisatoren, Lichtschutzmitteln, Verarbeitungshilfsmittel, Endblockverstärkerharzen, Polymeren, insbesondere elastomerer Natur.

13. Klebemasse nach zumindest einem der vorhergehenden Ansprüche,
**dadurch gekennzeichnet, dass**
die Haftklebemasse einen oder mehrere Füllstoffe enthält,
vorzugsweise nanoskalige Füllstoffe, transparente Füllstoffe und/oder Getter- und/oder Scavenger-Füllstoffe

14. Klebemasse nach zumindest einem der vorhergehenden Ansprüche,
**dadurch gekennzeichnet, dass**
die Klebemasse im sichtbaren Licht des Spektrums (Wellenlängenbereich von etwa 400 nm bis 800 nm) transparent ist.

15. Klebemasse nach zumindest einem der vorhergehenden Ansprüche,
**dadurch gekennzeichnet, dass**
die Klebemasse einen Haze kleiner 5,0 %, bevorzugt kleiner 2,5 % zeigt.

16. Klebeband enthaltend zumindest eine Schicht einer Klebemasse nach zumindest einem der vorangehenden Ansprüche und einen Träger,
**dadurch gekennzeichnet, dass**
der Träger eine Permeationsbarriere von WVTR < 0,1 g/(m² d) und OTR < 0,1 cm³/(m² d bar) aufweist.

17. Klebeband nach Anspruch 16,
**dadurch gekennzeichnet, dass**
der Träger eine beschichtete Kunststofffolie ist.

18. Klebeband nach Anspruch 16,
**dadurch gekennzeichnet, dass**
der Träger eine Schicht eines flexiblen Dünnglases mit einer Schichtdicke von höchstens 1 mm, bevorzugt höchstens 100 µm aufweist, vorzugsweise der Träger aus einer Schicht eines Dünnglases mit einer Schichtdicke von höchstens 1 mm besteht, wobei weiter vorzugsweise das Dünnglas ein Borosilikatglas oder ein alkalifreies Aluminoborosilikatglas ist.

19. Klebeband nach Anspruch 18,
**dadurch gekennzeichnet, dass**
das Dünnglas in bandförmiger Geometrie vorliegt.

20. Verwendung einer Klebemasse oder eines mit der Klebemasse gebildeten ein- oder doppelseitig klebenden Klebebands nach zumindest einem der vorhergehenden Ansprüche zur Kapselung einer (opto-)elektronischen Anordnung.

21. Verwendung nach Anspruch 20,
**dadurch gekennzeichnet, dass**
die Haftklebemasse und/oder die zu kapselnden Bereiche der elektronischen Anordnung vor, während und/oder nach der Applikation der Haftklebemasse erwärmt werden.

22. Verwendung nach Anspruch 20 oder 21,
**dadurch gekennzeichnet, dass**
die Haftklebemasse nach der Applikation auf der elektronischen Anordnung teil- oder endvernetzt wird.

23. Elektronische Anordnung mit einer elektronischen Struktur, insbesondere einer organischen elektronischen Struktur, und einer Haftklebmasse,
wobei die elektronische Struktur zumindest teilweise durch die Haftklebmasse gekapselt ist,
**dadurch gekennzeichnet,**
**dass** die Haftklebmasse gemäß zumindest einem der vorherigen Ansprüche ausgebildet ist.

## Claims

1. Adhesive particularly for encapsulating an electronic assembly against permeants, comprising
(a) at least one copolymer comprising at least isobutylene or butylene as comonomer kind and at least one comonomer kind which - considered as hypothetical homopolymer - has a softening temperature of greater than 40°C,
(b) at least one kind of an at least partly hydrogenated tackifier resin,
(c) at least one kind of a reactive resin based on acrylates or methacrylates having a softening temperature of less than 40°C, preferably less than 20°C,
(d) at least one kind of a photoinitiator for initiating radical curing.

2. Adhesive according to Claim 1,
**characterized in that**
the copolymer or copolymers is or are random, alternating, block, star and/or graft copolymers having a molar mass M_{w} of 300 000 g/mol or less, preferably 200 000 g/mol or less.

3. Adhesive according to Claim 1 or 2,
**characterized in that**
the copolymer or copolymers is or are block, star and/or graft copolymers which contain at least one kind of a first polymer block ("soft block") having a softening temperature of less than -20°C and at least one kind of a second polymer block ("hard block") having a softening temperature of greater than +40°C.

4. Adhesive according to Claim 3,
**characterized in that**
the soft block is of apolar construction and comprises butylene or isobutylene as homopolymer block or copolymer block, the latter preferably copolymerized with itself or with one another or with further comonomers, more preferably apolar comonomers.

5. Adhesive according to Claim 3 or 4,
**characterized in that**
the hard block is constructed from styrene, styrene derivatives and/or from other aromatic or (cyclo)aliphatic hydrocarbon monomers or from methacrylates or from acrylates.

6. Adhesive according to at least one of the preceding claims,
**characterized in that**
the at least one block copolymer is a triblock copolymer constructed from two terminal hard blocks and one middle soft block.

7. Adhesive according to at least one of the preceding claims,
**characterized in that**
the tackifier resin or resins has or have a degree of hydrogenation of at least 70%, more preferably of at least 95%.

8. Adhesive according to at least one of the preceding claims,
**characterized in that**
the adhesive comprises at least one resin which has a DACP of more than 30°C and a MMAP of more than 50°C, preferably a DACP of more than 37°C and an MMAP of more than 60°C.

9. Adhesive according to at least one of the preceding claims,
**characterized in that**
the adhesive comprises at least one reactive resin which is aliphatic or cycloaliphatic in nature.

10. Adhesive according to at least one of the preceding claims,
**characterized in that**
the adhesive comprises photoinitiators which absorb UV light below 350 nm and which permit radical curing.

11. Adhesive according to at least one of the preceding claims,
**characterized in that**
the adhesive comprises photoinitiators which absorb UV light above 250 nm and below 350 nm.

12. Adhesive according to at least one of the preceding claims,
**characterized in that**
the pressure-sensitive adhesive comprises one or more additives,
preferably selected from the group consisting of plasticizers, primary antioxidants, secondary antioxidants, process stabilizers, light stabilizers, processing assistants, endblock reinforcer resins, polymers, more particularly elastomeric in nature.

13. Adhesive according to at least one of the preceding claims,
**characterized in that**
the pressure-sensitive adhesive comprises one or more fillers,
preferably nanoscale fillers, transparent fillers and/or getter and/or scavenger fillers.

14. Adhesive according to at least one of the preceding claims,
**characterized in that**
the adhesive is transparent in the visible light of the spectrum (wavelength range from about 400 nm to 800 nm).

15. Adhesive according to at least one of the preceding claims,
**characterized in that**
the adhesive exhibits a haze of less than 5.0%, preferably less than 2.5%.

16. Adhesive tape comprising at least one layer of an adhesive according to at least one of the preceding claims and a carrier,
**characterized in that**
the carrier has a permeation barrier of WVTR < 0.1 g/(m² d) and OTR < 0.1 cm³/(m² d bar).

17. Adhesive tape according to Claim 16,
**characterized in that**
the carrier is a coated polymeric film.

18. Adhesive tape according to Claim 16,
**characterized in that**
the carrier has a layer of a flexible thin glass with a layer thickness of not more than 1 mm, preferably not more than 100 µm, the carrier preferably consisting of a layer of a thin glass with a layer thickness of not more than 1 mm, and with further preference the thin glass is a borosilicate glass or an alkali-free aluminoborosilicate glass.

19. Adhesive tape according to Claim 18,
**characterized in that**
the thin glass is present in tape-like geometry.

20. Use of an adhesive or of a single-sided or double-sided adhesive tape formed with the adhesive according to at least one of the preceding claims for encapsulating an (opto)electronic assembly .

21. Use according to Claim 20,
**characterized in that**
the pressure-sensitive adhesive and/or the regions of the electronic assembly that are to be encapsulated are heated before, during and/or after the application of the pressure-sensitive adhesive.

22. Use according to Claim 20 or 21,
**characterized in that**
the pressure-sensitive adhesive is cured partly or to completion on the electronic assembly after application.

23. Electronic assembly having an electronic structure, more particularly an organic electronic structure, and a pressure-sensitive adhesive,
the electronic structure being at least partly encapsulated by the pressure-sensitive adhesive,
**characterized in that**
the pressure-sensitive adhesive is designed according to at least one of the preceding claims.

## Revendications

1. Masse adhésive, notamment pour l'encapsulation d'un agencement électronique contre les perméants, comprenant :
(a) au moins un copolymère contenant au moins de l'isobutylène ou du butylène en tant que type de comonomère et au moins un type de comonomère qui présente, en tant qu'homopolymère hypothétique, une température de ramollissement supérieure à 40 °C,
(b) au moins un type d'une résine adhésive au moins partiellement hydrogénée,
(c) au moins un type d'une résine réactive à base d'acrylates ou de méthacrylates ayant une température de ramollissement inférieure à 40 °C, de préférence inférieure à 20 °C,
(d) au moins un type d'un photoinitiateur pour l'initiation d'un durcissement radicalaire.

2. Masse adhésive selon la revendication 1, **caractérisée en ce que** le ou les copolymères sont des copolymères statistiques, alternés, séquencés, en étoile et/ou greffés ayant une masse molaire M_{w} de 300 000 g/mol ou moins, de préférence de 200 000 g/mol ou moins.

3. Masse adhésive selon la revendication 1 ou 2, **caractérisée en ce que** le ou les copolymères sont des copolymères séquencés, en étoile et/ou greffés, qui comprennent au moins un type d'une première séquence polymère (« séquence souple ») ayant une température de ramollissement inférieure à -20 °C et au moins un type d'une deuxième séquence polymère (« séquence dure ») ayant une température de ramollissement supérieure à +40 °C.

4. Masse adhésive selon la revendication 3, **caractérisée en ce que** la séquence souple est configurée sous forme apolaire et contient du butylène ou de l'isobutylène en tant que séquence homopolymère ou séquence copolymère, cette dernière copolymérisant préférence avec elle-même ou l'une avec l'autre ou avec d'autres comonomères apolaires particulièrement préférés.

5. Masse adhésive selon la revendication 3 ou 4, **caractérisée en ce que** la séquence dure est formée à partir de styrène, de dérivés de styrène et/ou d'autres monomères hydrocarbonés aromatiques ou (cyclo)aliphatiques ou à partir de méthacrylates ou à partir d'acrylates.

6. Masse adhésive selon au moins l'une quelconque des revendications précédentes, **caractérisée en ce que** ledit au moins un copolymère séquence consiste en un copolymère triséquencé, qui est formé à partir de deux séquences dures terminales et une séquence souple centrale.

7. Masse adhésive selon au moins l'une quelconque des revendications précédentes, **caractérisée en ce que** la ou les résines adhésives présentent un degré d'hydrogénation d'au moins 70 %, de manière davantage préférée d'au moins 95 %.

8. Masse adhésive selon au moins l'une quelconque des revendications précédentes, **caractérisée en ce que** la masse adhésive contient au moins une résine qui présente une valeur DACP de plus de 30 °C et une valeur MMAP de plus de 50 °C, de préférence une valeur DACP de plus de 37 °C et une valeur MMAP de plus de 60 °C.

9. Masse adhésive selon au moins l'une quelconque des revendications précédentes, **caractérisée en ce que** la masse adhésive contient au moins une résine réactive, qui est de nature aliphatique ou cycloaliphatique.

10. Masse adhésive selon au moins l'une quelconque des revendications précédentes, **caractérisée en ce que** la masse adhésive contient des photoinitiateurs, qui absorbent la lumière UV en dessous de 350 nm et permettent un durcissement radicalaire.

11. Masse adhésive selon au moins l'une quelconque des revendications précédentes, **caractérisée en ce que** la masse adhésive contient des photoinitiateurs qui absorbent la lumière UV au-dessus de 250 nm et en dessous de 350 nm.

12. Masse adhésive selon au moins l'une quelconque des revendications précédentes, **caractérisée en ce que** la masse adhésive sensible à la pression contient un ou plusieurs additifs, de préférence choisis dans le groupe constitué par les plastifiants, les antioxydants primaires, les antioxydants secondaires, les stabilisateurs de procédé, les agents photoprotecteurs, les adjuvants d'usinage, les résines de renforcement de séquences terminales, les polymères, notamment de nature élastomère.

13. Masse adhésive selon au moins l'une quelconque des revendications précédentes, **caractérisée en ce que** la masse adhésive sensible à la pression contient une ou plusieurs charges, de préférence des charges nanométriques, des charges transparentes et/ou des charges de dégazage et/ou de piégeage.

14. Masse adhésive selon au moins l'une quelconque des revendications précédentes, **caractérisée en ce que** la masse adhésive est transparente dans la lumière visible du spectre (plage de longueurs d'onde allant d'environ 400 nm à 800 nm).

15. Masse adhésive selon au moins l'une quelconque des revendications précédentes, **caractérisée en ce que** la masse adhésive présente un trouble inférieur à 5,0 %, de préférence inférieur à 2,5 %.

16. Bande adhésive contenant au moins une couche d'une masse adhésive selon au moins l'une quelconque des revendications précédentes et un support, **caractérisée en ce que** le support présente une barrière à la perméation de WVTR < 0,1 g/(m² d) ou ORT < 0,1 cm³/(m² d bar).

17. Bande adhésive selon la revendication 16, **caractérisée en ce que** le support est un film en matière plastique revêtu.

18. Bande adhésive selon la revendication 16, **caractérisée en ce que** le support comprend une couche d'un verre mince flexible ayant une épaisseur de couche d'au plus 1 mm, de préférence d'au plus 100 µm, de préférence le support est constitué par une couche d'un verre mince ayant une épaisseur de couche d'au plus 1 mm, le verre mince étant par ailleurs de préférence un verre de borosilicate ou un verre d'aluminoborosilicate sans alcali.

19. Bande adhésive selon la revendication 18, **caractérisée en ce que** le verre mince se présente en une géométrie en forme de bande.

20. Utilisation d'une masse adhésive ou d'une bande adhésive mono- ou double face formée avec la masse adhésive selon au moins l'une quelconque des revendications précédentes pour l'encapsulation d'un agencement (opto-)électronique.

21. Utilisation selon la revendication 20, **caractérisée en ce que** la masse adhésive sensible à la pression et/ou les zones à encapsuler de l'agencement électronique sont chauffées avant, pendant et/ou après l'application de la masse adhésive sensible à la pression.

22. Utilisation selon la revendication 20 ou 21, **caractérisée en ce que** la masse adhésive sensible à la pression est partiellement réticulée ou réticulée aux extrémités après l'application sur l'agencement électronique.

23. Agencement électronique comprenant une structure électronique, notamment une structure électronique organique, et une masse adhésive sensible à la pression, la structure électronique étant au moins partiellement encapsulée par la masse adhésive sensible à la pression, **caractérisé en ce que**
la masse adhésive sensible à la pression est configurée selon au moins l'une quelconque des revendications précédentes.
